# EUROPEAN PATENT APPLICATION

(11) **EP 4 718 989 A1**
(43) Date of publication of application: **01.04.2026**
(21) Application number: 24202829.8
(22) Date of filing: 26.09.2024
(51) Int. Cl.: H10D 84/01, H10D 30/66, H10D 84/83

(54) **SEMICONDUCTOR DIE WITH A VERTICAL TRANSISTOR DEVICE**

(71) Applicant: Infineon Technologies Austria AG, 9500 Villach (AT)
(72) Inventor: NOEBAUER, Gerhard, 9500 Villach (AT); FEIL, Thomas Martin, 9523 Villach (AT); VIELEMEYER, Martin Henning, 9500 Villach (AT); NAIK, Harsh, 90245 El Segundo (US)
(74) Representative: Szynka Smorodin Patentanwälte Partnerschaft mbB

(57) **Abstract**

The disclosure relates to a semiconductor die (1) with a semiconductor body (10), the semiconductor die (1) comprising: a vertical transistor device (20) with a first load region (21) and a second load region (22) at opposite sides (10.1, 10.2) of the semiconductor body (10); an additional transistor device (40) with a source region (41) at a first side (10.1) of the semiconductor body (10), a gate trench (45), a body region (47) aside the gate trench (45) and a drain region (42) below the body region (47); an electrical isolation (60) in the semiconductor body (10); a vertical contact element (80) extending from the first side (10.1) into the semiconductor body (10); wherein the electrical isolation (60) is arranged laterally between the vertical transistor device (20) and the additional transistor device (40), and wherein the vertical contact element (80) makes electrical contact to the drain region (42) of the additional transistor device (40) and connects the drain region (42) to the first side (10.1) of the semiconductor body (10).

## Description

### TECHNICAL FIELD

The present disclosure relates to a semiconductor die with a semiconductor body, comprising a vertical transistor device.

### BACKGROUND

A vertical transistor device may have a first load region at a first side of the semiconductor body and a second load region at a vertically opposite second side of the semiconductor body, e.g. a source region at the first side and a drain region at the second side. The first and second load region may be made of a first doping type, e.g. in combination with a body region arranged vertically between and made of a second doping type.

### SUMMARY

Examples of the present application are directed at an advantageous semiconductor die with a semiconductor body.

In an embodiment, the semiconductor die comprises an additional transistor device in addition to the vertical transistor device, wherein an electrical isolation is arranged laterally between the vertical transistor device and the additional transistor device. The additional transistor device comprises a source region at the first side of the semiconductor body and a drain region below, wherein a vertical contact element is provided and connects the drain region of the additional transistor device to the first side of the semiconductor body. In other words, the vertical contact element is provided to route a drain potential of the additional transistor device to the first side of the semiconductor body.

Having the source region arranged at the first side of the semiconductor body and the drain region arranged below, the additional transistor device as such may be configured for a vertical current flow. In detail, it can comprise a gate trench extending from the first side into the semiconductor body and a body region arranged aside the gate trench, wherein the drain region is arranged below the body region (e.g. with a drift region in between, see in detail below). In a conducting state, a vertical current flow through the additional transistor device results, e.g. vertically through the channel region aside the gate trench. In detail, the current flow may have a first vertical portion between the source and the drain region of the additional transistor device, a lateral portion in the drain region of the additional transistor device and a second vertical portion through the vertical contact element. Via the vertical contact element, i.e. second portion, the drain region of the additional transistor device can for instance be connected to a terminal of the vertical transistor device, for example gate terminal.

Since the load regions of the vertical device are arranged on opposite sides of the semiconductor body, e.g. the source region on the first side and the drain region on the second side, the vertical transistor device is configured for a vertical current flow. Consequently, a combination with the additional transistor device, which is configured for a vertical current flow as well (in the first vertical portion), may have advantages as to an integration into the same die. It may allow for a reuse of manufacturing steps of the vertical transistor device, see in further detail below. However, in combination with the vertical contact element, a drain contact or connection of the additional transistor device can be provided on the same side as its source region, i.e. at the first side of the semiconductor body. In other words, considering its contacts (not current flow), a lateral device having its source and drain contact on the same side is realized, which can for instance be advantageous in terms of a further connection and wiring.

Further embodiments and features are provided in the claims and throughout this disclosure. Therein, the individual features shall be disclosed independently of a specific claim category, the disclosure relates to apparatus and device aspects but also to method and use aspects. If for instance a die manufactured in a specific way is described, this is also a disclosure of a respective manufacturing process, and vice versa. In general words, an approach of this application is to combine a vertical transistor device having its load contacts at opposite sides with an additional transistor device having its load contacts at the same side of the semiconductor body, wherein both devices are configured for a vertical current flow through their respective channel. In this respect, the additional transistor device may be considered as a vertical device which blocks the full high voltage (e.g. same voltage like the vertical transistor device). For example, a doping of a body region of the vertical transistor device and the additional transistor device may be comparable (e.g., deviate by at most 20% or at most 10%) or may be substantially the same. In examples, the body region of the additional transistor device and the body region of the vertical transistor device may be formed in a same manufacturing step using a j oint implantation step or in a j oint epitaxial growth step.

The electrical isolation may provide for a lateral isolation between the vertical transistor device and the additional transistor device, e.g. isolate the doped regions of the devices from each other. Though a junction isolation is conceivable in general, an embodiment relates to a trench isolation. It may comprise a deep trench, e.g. extending from the first side into the semiconductor body. In detail, the deep trench, as viewed in a vertical cross-section, may intersect the semiconductor body completely, i.e. reach all the way from the first side to the second side of the semiconductor body. As seen in a vertical top view, the electrical isolation may extend around the additional transistor device, e.g. form a closed line, see in detail below.

In a wiring layer above the first side of the semiconductor body, e.g. in a metallization layer, a connection between the vertical and the additional transistor device may be formed. In other words, as seen in a vertical top view, a lateral connection element, e.g. conductor line, may extend across the electrical isolation, for instance across the trench isolation. As discussed above, it may connect the vertical contact element, i.e. drain domain of the additional transistor device, to a terminal of the vertical transistor device, e.g. to the gate terminal. This may lead to a pull-down configuration, where the additional transistor device may be used as a pull-down transistor for the vertical transistor device (e.g., with the connection being integrated in the semiconductor die by way of the metallization layer). In general, however, a wiring between the devices is not necessarily integrated in the die, it may for instance be realized externally, e.g. on a board or in a package of the die.

The semiconductor body may comprise at least one of a semiconductor substrate (e.g. made of the first doping type), and one or more epitaxial layers. The one or more epitaxial semiconductor layers may be arranged on the semiconductor substrate, e.g. on a first side (frontside) of the semiconductor substrate. That surface of an uppermost epitaxial layer, which faces away from the substrate, can form the first side of the semiconductor body. The second side can for instance be that side of the substrate which faces away from the epitaxial layer or layers. Independently of an epitaxial layer or layer stack, the first side and the second side are those sides of the semiconductor body which lie vertically opposite to each other, i.e. face away from each other with respect to the vertical direction.

The vertical direction, to which "vertical" or "vertically" refer, lies for instance perpendicular to a surface of the die, e.g. the surface of a substrate or of an epitaxial layer formed on the substrate. Inside the semiconductor body, "above" means closer to the first side of the semiconductor body and "below" means closer to the second side of the semiconductor body. An "upper end" of an element or region in the semiconductor body is that end which lies closer to or in the first side of the semiconductor body, whereas a "lower end " is that end which lies closer to or in the second side. "Lateral" or "laterally" referred to the lateral directions perpendicular to the vertical direction, in which for instance the die area is taken.

The first load region, e.g. source region, and the second load region, e.g. drain region, of the vertical device are disposed at the vertically opposite sides of the semiconductor body, wherein the "first side" can also be referred to as a frontside and the "second side" as a backside. In a body region of the device, a channel can be formed by applying a voltage to the gate electrode of the vertical device. Even though the transistor device as a whole is considered to be "vertical" due to its vertically opposite source and drain region, a lateral channel is conceivable in general, e. g. in case of a gate region disposed on top of the body region (and a source region laterally aside the latter). In an embodiment, however, the vertical transistor device has a gate electrode in a gate trench laterally aside the body region, wherein the source region is arranged above the body region and the drain region is arranged below, e.g. with a drift arranged between the body region and the drain region.

In an embodiment, the drain region of the additional transistor device is formed in a doped region which, as seen in a vertical cross-section, extends into a contact area laterally aside the additional transistor device. The vertical contact element is arranged in the contact area and is electrically connected to the doped region. In other words, the lateral portion of the current flow discussed above may have a first lateral section in the drain region of the additional transistor device and an adjacent second lateral section in the contact area aside. Therein, the first and second lateral section are formed in the same doped region.

The doped region can for instance be formed by the semiconductor substrate (see above). In the area of the vertical transistor device, the same layer, e.g. the semiconductor substrate, may form the second load region of the vertical transistor device, e.g. the drain region. Therein, the respective source and body region and, if provided, drift region of the vertical and the additional transistor device may be formed in an epitaxial layer or layers disposed on the semiconductor substrate.

In an embodiment, the electrical isolation, as seen in a vertical top view, forms a closed line around the additional transistor device and the vertical contact element. In other words, the additional transistor device and, in addition, the contact area arranged aside are enclosed by the closed line, e.g. by the deep trench (such as a deep trench isolation). As discussed in further detail below, a backside insulating layer may be arranged on the second side of semiconductor body in an area enclosed by the electrical isolation.

In an embodiment, an isolation trench is provided, which may be different from the electrical isolation, e.g. deep trench isolation, formed between the vertical and the additional transistor device. The isolation trench may be arranged laterally between the additional transistor device and the vertical contact element, for instance in an area defined or enclosed by the electrical isolation/deep trench isolation. The isolation trench can for instance extend from the first side into the semiconductor, having its lower end for instance above the doped region, in which the drain region of the additional transistor device is formed, e.g. above the semiconductor substrate. It can for example have the same width and/or depth like the gate trench or trenches of the additional transistor device, e.g. be manufactured simultaneously. Independently of these details, the isolation trench may provide a separation between the source domain of the additional transistor device and its drain domain routed up via the vertical contact element.

In an embodiment, an insulating backside layer is arranged on the second side of the semiconductor body, i.e. on the backside. Together with the electrical isolation, e.g. deep trench, the insulating backside layer may form an isolation well. It may embed the additional transistor device, as well as the vertical contact element, vertically and laterally.

The insulating backside layer may be combined with a backside metallization, which can be deposited after the insulating backside layer has been formed. The insulating backside layer may be provided in an area laterally defined by the electrical isolation, wherein an area of the second side, in which the vertical transistor device is arranged, is not covered by the insulating backside layer. Consequently, the backside metallization can make an electrical contact to the semiconductor body in the area of the vertical transistor device, but be electrically isolated from the semiconductor body in the area of the additional transistor device. In other words, the backside metallization may extend in both areas, of the vertical transistor device and of the additional transistor device, which can for instance be of interest with respect to a wafer or die bow. A reduced bow may, for example, be advantageous for a soldering and/or a stacking of the die in a package. Further, the backside metallization can, for example, have advantages in terms of a cooling, because the connection area to the next metal layers in the package may be improved. Apart from that, a continuous (non-structured) backside metallization may be easier in terms of manufacturing.

In an embodiment, the vertical contact element, as seen in a vertical top view, is arranged aside the additional transistor device with respect to a first lateral direction. Therein, the vertical contact element may have an elongated lateral extension along the additional transistor device in a second lateral direction (length direction). In case that an isolation trench is provided, it may be arranged between the additional transistor device and the vertical contact element with respect to the first lateral direction.

In an embodiment, the gate trench of the additional transistor device has an elongated lateral extension in the second direction (length direction). The first lateral direction may lie perpendicular thereto and be for instance referred to as a transverse or width direction. As seen in a vertical top view, the elongated gate trench and the vertical contact element arranged aside may extend in parallel to each other. In other words, the vertical contact element, as seen in a vertical top view, may have at least a portion which lies parallel to the gate trench or trenches of the additional transistor device, e.g. parallel to a stripe pattern formed by the device cells of the additional transistor device.

In an embodiment, the vertical contact element extends on at least two sides of the additional transistor device, e.g. on two adjacent sites (L-shape) and/or on two opposite sides (with respect to the first or to the second lateral direction). The vertical contact element, as seen in a vertical top view, may enclose the additional transistor device at least in a U-shape, i.e. extend on at least three sides thereof. In case of the U-shape, two opposite arms of the U-shape can for instance lie opposite to each other with respect to the second lateral direction (length direction), i.e. be connected by the elongated portion extending in the first lateral direction.

In an embodiment, the vertical contact element and the additional transistor device are arranged at a lateral distance of not more than 20 µm, a further upper limit being for instance not more than 15 µm. Possible lower limits can for instance be at least 3 µm, 6 µm or 9 µm. In detail, the lateral distance may be taken in a plane in which the first side of the semiconductor body lies, e.g. as smallest distance (clearance) between the vertical contact element and the additional transistor device. The distance can for instance be taken between a sinker implant of the vertical contact element and a channel region of the additional transistor device, e.g. that channel region which is arranged closest to the vertical contact element in case of a plurality of device cells.

In an embodiment, the vertical contact element comprises a sinker implant in the semiconductor body. It can for instance form a lower portion, e.g. lowermost portion, of the vertical contact element, e.g. reach all the way to the doped region (in which the drain region of the additional transistor device is formed, see above). The sinker implant can for instance extend to a greater depth than the gate trench of the additional transistor device. An upper end of the sinker implant may in general be arranged in the first side of the semiconductor body or may be arranged below, e.g. at a larger vertical depth than a lower end of the source region of the additional transistor device. In case of a semiconductor die comprising an electrical through contact between the first side and the second side of the semiconductor body, see in detail below, the through contact may comprise the same type of sinker implant as the vertical contact element.

In an embodiment, an insulating layer is arranged on the first side of the semiconductor body, wherein a metal plug of the contact element intersects the insulating layer vertically. In addition, it may extend into the semiconductor body, i.e. have a lower end at a vertical distance from the first side of the semiconductor body. In combination with the sinker implant, which may form a lower portion of the vertical contact element, the metal plug may form an upper portion of the vertical contact element. The metal plug can for instance be formed of the same metal material like the vertical interconnects of the additional and/or vertical transistor device, e.g. source/body contacts, the metal plug and the vertical interconnects being for instance manufactured simultaneously.

In an embodiment, each of the vertical and the additional transistor device comprises at least one transistor device cell, wherein the transistor device cells of the vertical and of the additional transistor device have for instance the same source doping and/or the same body doping and/or the same trench depth and/or the same gate oxide thickness. As mentioned above, this may allow for a reuse of processing step, e.g. reduce an integration effort for the additional transistor device. By way of example, the device cells of the vertical and the additional transistor device may be identical in construction (e.g., they may only vary with respect to each other due to minor manufacturing variations).

A lower end of the body region of the additional transistor device may lie on the same vertical height as a lower end of the body region of the vertical transistor device. Alternatively or in addition, a lower end of the source region of the additional transistor device may lie on the same vertical height as a lower end of the source region of the vertical transistor device. Alternatively or in addition, an upper end of the drain region of the additional transistor device may lie below a lower end of the gate trench of the additional and/or vertical transistor device, e.g. lie on the same vertical height as an upper end of the drain region of the vertical device.

In an embodiment, the gate trench of the additional transistor device comprises a field electrode below the gate electrode. The field electrode may capacitively couple to a drift region of the additional transistor device, as discussed above. Alternatively or in addition, a gate trench of the vertical device may comprise a gate electrode and a field electrode below, wherein the field electrode capacitively couples to a drift region of the vertical transistor device. Both, the gate trench of the vertical and the gate trench of the additional transistor device may respectively have an elongated lateral extension, e.g. form a stripe as seen in a vertical top view. In a respective elongated gate trench, a respective elongated gate electrode may be arranged. In detail, each of the devices may comprise a plurality of gate trenches (device cells), e.g. a plurality of parallel stripes, the stripes of the vertical transistor device being for instance arranged in parallel to the stripes of the additional transistor device.

In an embodiment, a gate contact of the additional transistor device, which makes electrical contact to the gate electrode, is arranged in a lateral intermediate portion of the elongated gate electrode. Related to a percentage dimensioning, with 0% at a first lateral end of the elongated gate electrode and 100% at the laterally opposite second end thereof, the gate contact can for instance be arranged between 30%-70%, e.g. between 40%-60%. In case of a field electrode arranged below the gate electrode in the trench, the field electrode may be contacted at one or at both of its lateral ends, i.e. laterally outside of the first and/or second end of the gate electrode (though a floating field electrode is conceivable as well).

In an embodiment, the additional transistor device is connected as a pulldown device to the vertical transistor device. In a conducting state, the additional transistor device may connect the gate terminal/electrode of the vertical transistor device to the ground domain, e.g. to the source domain in case of a low side switch. Via the vertical contact element, the gate terminal/electrode of the vertical transistor device may be connected to the drain region of the additional transistor device, e.g. via a conductor line extending across the electrical isolation. The pulldown device may be driven externally, for instance by an IC.

In an embodiment, a second electrical isolation is formed in the semiconductor body, for example a trench isolation, e.g. a deep trench, as discussed above for the electrical isolation between the devices. The second electrical isolation may form a closed line and define a through-contact area, in which a through-contact is formed. The through-contact may locally connect the first side and the second side of the semiconductor body to each other, e.g. allow for a current or potential routing from one side to the other.

By way of example, the through-contact may comprise a sinker implant, e.g. in combination with a metal plug above and/or a doped region below. The latter may be formed in the same layer as the drain region of the additional transistor device and/or the drain region of the vertical transistor device, e.g. be formed in the semiconductor substrate.

In total, one or a plurality of through-contacts may be formed in the semiconductor body. For example, a gate connection to the gate electrode of the vertical or additional transistor device may be provided at the second side of the semiconductor body via a through-contact. Alternatively or in addition, a drain connection to the drain region of the additional transistor device may be provided on the second side of the semiconductor body. In case of the pull-down device, the drain connection of the additional transistor device may also be a gate connection of the vertical transistor device. Further, alternatively or in addition, a source connection or connections may be provided on a second side of the semiconductor body, for the additional and/or for the vertical transistor device.

In an embodiment, the semiconductor body has a thickness of at most 40 µm, further upper limits being for instance at most 30 µm or 20 µm. The additional transistor device can, for example, be particularly beneficial for a thin wafer or die. Lower limits can for instance be at least 10 µm or 15 µm. A major portion (> 50%) of the thickness may be contributed by the semiconductor substrate, a minor portion (< 50%) by the epitaxial layer or layers. This may be realized, e.g., by removing portions of the substrate from the backside of the semiconductor body.

In an embodiment, a method of manufacturing the semiconductor die may comprise:
- forming the vertical transistor device,
- forming the additional transistor device,
- forming the electrical isolation in the semiconductor body,
- forming the vertical contact element.

As discussed above, the vertical and the additional transistor device may, at least to some extent, be formed simultaneously, e.g. the gate trenches being etched simultaneously and/or the gate oxides being formed simultaneously and/or the gate electrodes being formed simultaneously and/or the field electrodes being formed simultaneously and/or the source regions being formed simultaneously and/or the body regions being formed simultaneously and/or the drift regions being formed simultaneously and/or the drain regions being formed simultaneously.

### BRIEF DESCRIPTION OF THE DRAWINGS

Below, the semiconductor die and method of manufacturing are explained in further detail by means of exemplary embodiments. Therein, the individual features can also be relevant in a different combination.
- Figure 1: shows a semiconductor die with a semiconductor body in a vertical cross-section;
- Figure 2: shows a detailed view of an additional transistor device;
- Figure 3: shows an additional transistor device in a vertical top view;
- Figure 4: shows a detailed view of a vertical transistor device;
- Figure 5: shows a vertical cross-section and illustrates metallization details;
- Figure 6: shows a circuit diagram with a pulldown device;
- Figure 7: illustrates an option for mounting a semiconductor die;
- Figure 8: summarizes some manufacturing steps in a flow diagram.

### PARTICULAR EMBODIMENT

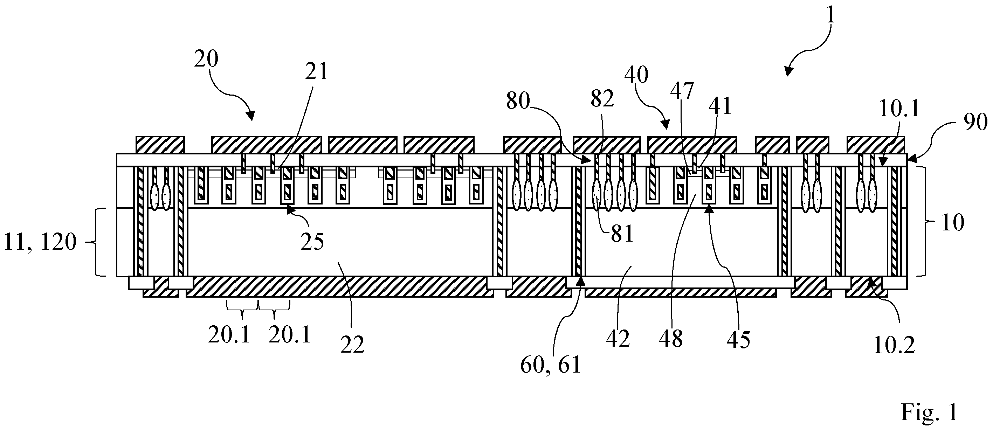

**Figure 1** shows a semiconductor die 1 with a semiconductor body 10. In the semiconductor die 1, a vertical transistor device 20 and an additional transistor device 40 are formed. Laterally between, an electrical isolation 60 is arranged. In the example shown, it comprises a deep trench 61 which reaches from a first side 10.1 to a second side 10.2 of the semiconductor body 10.

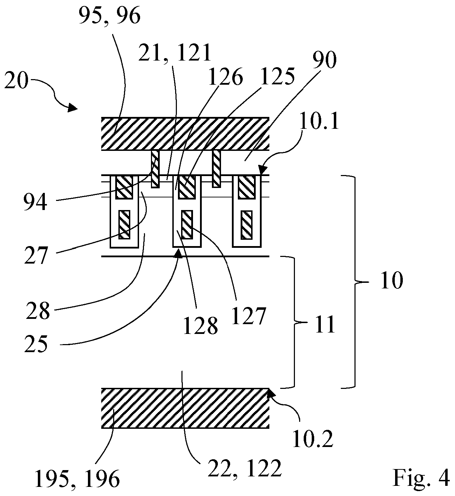

The vertical device 20, which is discussed in further detail with reference to figure 4, comprises a plurality of device cells 20.1 and has a first load region 21 at the first side 10.1 and a second load region 22 at the second side 10.2 of the semiconductor body 10. The additional transistor device 40 has a source region 41 at the first side 10.1 of the semiconductor body 10 and a body region 47 below the source region 41. Further, it comprises a drain region 42 below the body region 47, wherein a drift region 48 is arranged vertically between the body region 47 and the drain region 42. The drift region 48 is made of the same doping type like the drain region 42, but with a lower doping concentration. In the example shown, the source region 41, drift region 48 and drain region 42 are n-doped, whereas the body region 47 is p-doped.

Laterally aside the additional transistor device 40, a vertical contact element 80 is arranged. It makes electrical contact to the drain region 42, i.e. to a doped region 120, in which the drain region 42 is formed and which extends also laterally aside the additional transistor device 40. The doped region 120 is formed by the semiconductor substrate 11. Via the doped region 120 and the vertical contact element 80, the drain region 42 of the additional transistor device 40 is connected to the first side 10.1 of the semiconductor body 10.

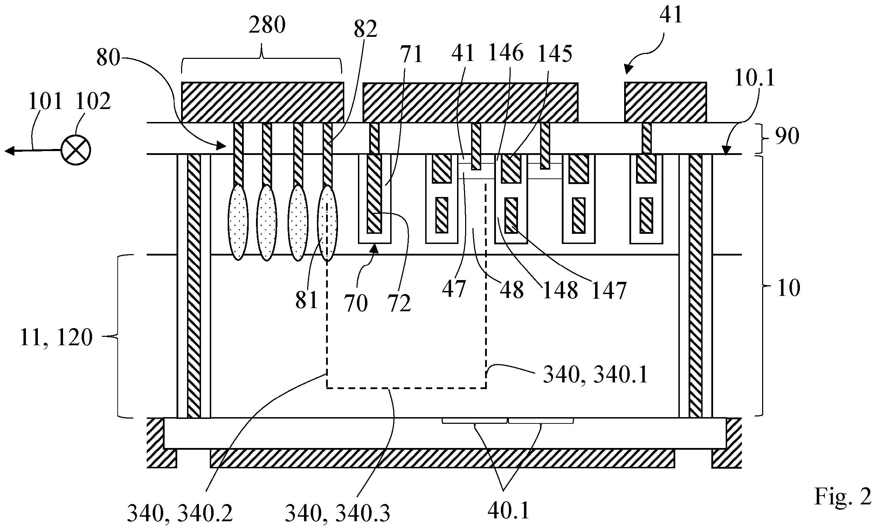

The vertical contact element 80 comprises a sinker implant 81 in a lower portion and a metal plug 82 in an upper portion. The metal plug 82 intersects an insulating layer 90 arranged on the first side 10.1 of the semiconductor body 10, as shown in further detail in figure 2.

**Figure 2** illustrates a contact area 280, which is arranged laterally aside the additional transistor device and is enclosed by the same electrical isolation 60, i.e. deep trench 61 in the example shown. The doped region 120, which is formed by semiconductor substrate 11, forms the drain region 42 of the additional transistor device 40 and extends into the contact area 280. There, the vertical contact element 80, i.e. sinker implant 81, makes electrical contact to the doped region 120.

Figure 2 also illustrates a current path 340 in the semiconductor body 10. It comprises a first vertical portion 340.1 through the additional transistor device 40 and a second vertical portion 340.2 through the vertical contact element 80. A lateral portion 340.3 extends in the doped region 120 between the first vertical portion 340.1 and the second vertical portion of 340.2.

An isolation trench 70 is arranged with respect to a first lateral direction 101 between the additional transistor device 40 and the vertical contact element 80. It extends from the first side 10.1 into the semiconductor body 10 and ends above the semiconductor substrate 11, e.g. in an epitaxial semiconductor layer or layer stack 12 arranged on the semiconductor substrate 11. In the example shown, it is filled with an oxide 71 and a conductive element 72, e.g. polysilicon.

In the gate trench 45 of the additional transistor device 40, a gate electrode 145 is arranged aside the body region 47, capacitively coupling to the body region 47 via a gate dielectric 146. A field electrode 147 is disposed below the gate electrode 145 in the same trench. It capacitively couples to the drift region 48 via a field dielectric 148. By way of example, the gate and field electrode 145, 147 may be made of polysilicon and the gate and field dielectric 146, 148 may be made of oxide.

The additional transistor device 40 comprises a plurality of additional transistor device cells 40.1 which are arranged consecutive in the first lateral direction 101. In a second lateral direction 102, the gate trench or trenches 45 respectively have an elongated lateral extension. This also applies to the gate electrode 145 and the field electrode 147, as well as to the isolation trench 70.

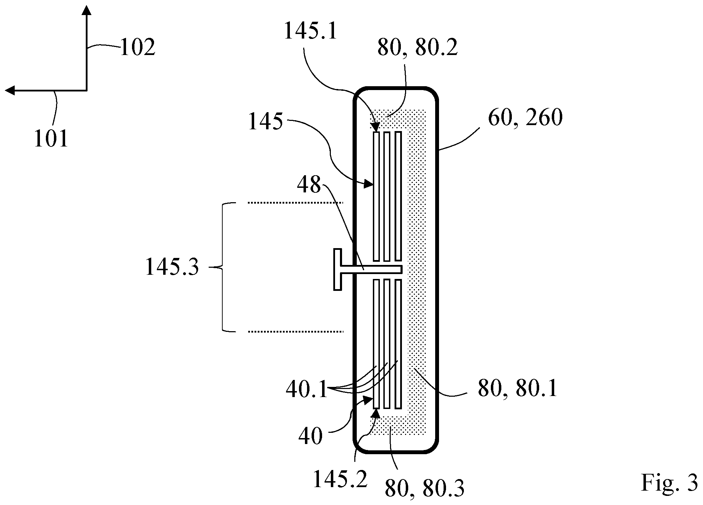

**Figure 3** shows a vertical top view and illustrates that the electrical isolation 60 forms a closed line 260 around the additional transistor device 40 and the vertical contact element 80. The additional transistor device 40, e.g. device cells 40.1, have an elongated lateral extension in the second lateral direction 102. The vertical contact element 80, i.e. a first portion 80.1 of the vertical contact element 80, is arranged aside the additional transistor device 40 with respect to the first lateral direction 101. The first portion 80.1 of the vertical contact element 80 has an elongated lateral extension along the additional transistor device 40.

In the example shown, the vertical contact element 80 additionally comprises a second portion 80.2 and a third portion 80.3, which are arranged on opposite sides with respect to the second lateral direction 102. Together with the first portion 80.1, they enclose the additional transistor device 40 in a U-shape. A gate contact 48 makes electrical contact to the gate electrode or electrodes 145. As to the second lateral direction 102, it is arranged in a lateral intermediate portion 145.3 of the gate electrode 145, e.g. spaced from lateral ends 145.1, 145.2 of the elongated gate electrode 145.

**Figure 4** shows a detailed view of a vertical transistor device 20. It has the first load region 21 at the first side 10.1 of the semiconductor body 10 and the second load region 22 at the second side 10.2 of the semiconductor body 10. In the example shown, the first load region 21 is a source region 121 and a second load region 22 is a drain region 122. Below the source region 121, a body region 27 and a drift region 28 are arranged. In this example, the source region 121, drift region 28 and drain region 122 are n-doped, whereas the body region 27 is p-doped.

In a gate trench 25, a gate electrode 125 is arranged. Via a gate dielectric 126, it capacitively couples to the body region 27. Below the gate electrode 125, a field electrode 127 is disposed in the gate trench 25. Via a field dielectric 128, it capacitively couples to the drift region 28.

Above the vertical transistor device 20, the metallization 95 forms a source plate 96. It is electrically connected to the source region 121 and to the body region 27 via vertical interconnects 94. A backside metallization 195, which is arranged on the second side 10.2 of the semiconductor body 10, forms a drain contact 196.

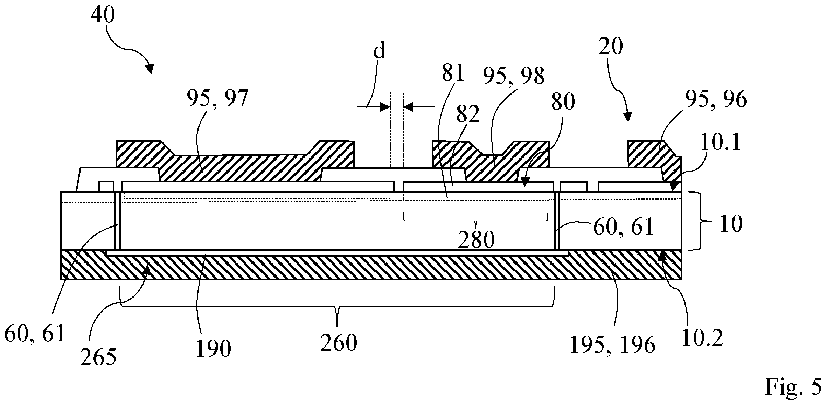

**Figure 5** illustrates some more metallization details. An additional source plate 97 is formed in the metallization 95 above the additional transistor device 40. Further, a drain plate 98 is formed above the vertical contact element 80, e.g. in the contact area 280. The vertical contact element 80 and the additional transistor device 40 are arranged at a lateral distance d from each other, e.g. around 12 µm in the example shown.

On the second side 10.2 of the semiconductor body 10, an insulating backside layer 190 is arranged in an area 260 enclosed by the electrical isolation 60. Together with the electrical isolation 60, i.e. deep trench 61, it forms an isolation well 265. The additional transistor device 40 and the vertical contact element 80 are embedded into the isolation well 265. The drain contact 196 extends across the area 260 but is electrically isolated from the additional transistor device 40 by the insulating backside layer 190.

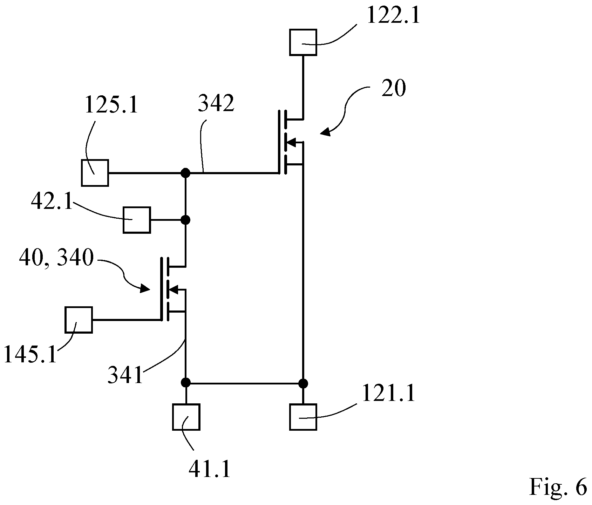

**Figure 6** illustrates a possible wiring of the vertical transistor device 20 and the additional transistor device 40 in a circuit diagram. In the example shown, the additional transistor device 40 is connected as a pulldown device 340 to the vertical transistor device 20. It connects a gate terminal of the vertical transistor device 20 to its source terminal, which is on ground potential in case of the low side switch shown. Further, a drain contact 122.1 and a gate contact 125.1 of the vertical transistor device 20 are shown.

The additional transistor device 40 is driven externally (e.g. by an IC) via the gate contact 145.1. A drain connection 342 between the drain terminal of the additional transistor device 40 and the gate terminal of the vertical transistor device 20 is integrated in the die, which also applies for a source connection 341 between the source terminal of the additional transistor device 40 and the ground domain. Further, a drain contact 42.1 and a source contact 41.1 are shown.

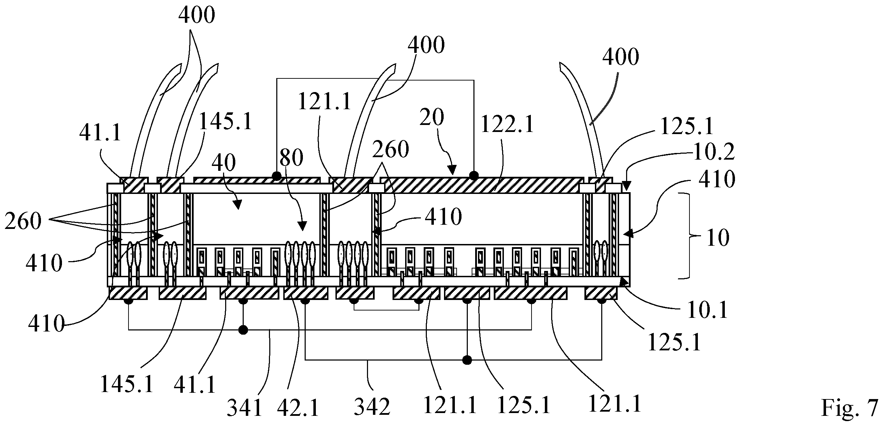

The connections 341, 342 are also illustrated in **figure 7****,** which shows a flipped die 1, see figure 1 in comparison. Figure 7 also illustrates the contacts as indicated in the circuit diagram of figure 6, i.e. the source contact 121.1, drain contact 122.1 and gate contact 125.1 of the vertical transistor device 20. Further, the source contact 41.1, drain contact 42.1 and gate contact 145.1 of the additional transistor device 40 are shown.

A plurality of through-contacts 410 are formed in the semiconductor body 10, each electrically isolated from the surrounding semiconductor body by a respective second electrical isolation 260. Via a respective metal plug, sinker implant and semiconductor substrate (not referenced in figure 7, same elements as discussed for the vertical contact element), the respective through-contact 410 forms an electrical connection to the second side 10.2. There, the respective contacts 41.1, 145.1, 121.1, 125.1 may be contacted by a respective bond wire 400, e.g. all connections may be made from the second side 10.2 (backside).

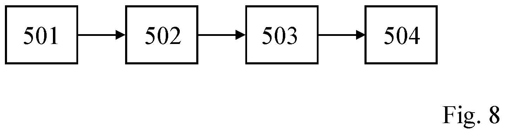

**Figure 8** summarizes some manufacturing steps in a flow diagram. The method may comprise forming 501 the vertical transistor device, forming 502 the additional transistor device, forming 503 the electrical isolation and forming 504 the vertical contact element. Though shown in a sequence, these steps may be integrated, i.e. be performed simultaneously (at least to some extent).

## Claims

1. A semiconductor die (1) with a semiconductor body (10), the semiconductor die (1) comprising:
a vertical transistor device (20), the vertical transistor device (20) comprising:
a first load region (21) and a second load region (22) at opposite
sides (10.1, 10.2) of the semiconductor body (10);
an additional transistor device (40), the additional transistor device (40) comprising:
a source region (41) at a first side (10.1) of the semiconductor body (10);
a gate trench (45) extending from the first side (10.1) into the semiconductor body (10);
a body region (47) aside the gate trench (45);
a drain region (42) below the body region (47);
an electrical isolation (60) in the semiconductor body (10);
a vertical contact element (80) extending from the first side (10.1) into the semiconductor body (10);
wherein the electrical isolation (60) is arranged laterally between the vertical transistor device (20) and the additional transistor device (40),
and wherein the vertical contact element (80) makes electrical contact to the drain region (42) of the additional transistor device (40) and connects the drain region (42) to the first side (10.1) of the semiconductor body (10).

2. The semiconductor die (1) of claim 1, wherein the drain region (42) of the additional transistor device (40) is formed in a doped region (120) which, as seen in a vertical cross-section, extends into a contact area (280) laterally aside the additional transistor device (40), wherein the vertical contact element (80) is arranged in the contact area (280) and makes electrical contact to the doped region (120).

3. The semiconductor die (1) of claim 2, wherein the electrical isolation (60), as seen in a vertical top view, forms a closed line (260) around the additional transistor device (40) and the vertical contact element (80).

4. The semiconductor die (1) of claim 2 or 3, comprising:
an isolation trench (70);
wherein the isolation trench (70) is arranged laterally between the additional transistor device (40) and the vertical contact element (80).

5. The semiconductor die (1) of any one of the preceding claims, comprising:
an insulating backside layer (190);
wherein the insulating backside layer (190) is arranged on the second side (10.2) of the semiconductor body in an area (260), which is laterally defined by the electrical isolation (60), and together with the electrical isolation (60) forms an isolation well (265).

6. The semiconductor die (1) of any one of the preceding claims, wherein the vertical contact element (80) is, as seen in a vertical top view, arranged with respect to a first lateral direction (101) aside the additional transistor device (40) and has an elongated lateral extension in a second lateral direction (102) along the additional transistor device (40).

7. The semiconductor die (1) of claim 6, wherein the gate trench (45) of the additional transistor device (40) has an elongated lateral extension in the second lateral direction (102).

8. The semiconductor die (1) of any one of the preceding claims, wherein the vertical contact element (80), as seen in a vertical top view, is arranged on at least two sides of the additional transistor device (40), in particular encloses the additional transistor device (40) at least in a U-shape.

9. The semiconductor die (1) of any one of the preceding claims, wherein a smallest lateral distance d between the vertical contact element (80) and the additional transistor device (40) is at most 20 µm.

10. The semiconductor die (1) of any one of the preceding claims, wherein the vertical contact element (80) comprises a sinker implant (81) in the semiconductor body (10).

11. The semiconductor die (1) of any one of the preceding claims, comprising:
an insulating layer (90) on the first side (10.1) of the semiconductor body (10);
wherein the vertical contact element (80) comprises a metal plug (82) which intersects the insulating layer (90) and extends into the semiconductor body (10).

12. The semiconductor die (1) of any one of the preceding claims, the vertical transistor device (20) and the additional transistor device (40) respectively comprising at least one transistor device cell (20.1, 40.1), wherein the at least one transistor device cell (20.1) of the vertical transistor device (20) and the at least one transistor device cell (40.1) of the additional transistor device (40) have at least one of: same source doping, same body doping, same trench depth, same gate oxide thickness.

13. The semiconductor die (1) of any one of the preceding claims, the vertical transistor device (20) comprising:
a gate trench (25) extending from the first side (10.1) into the semiconductor body (10);
wherein the gate trench (25) of the vertical transistor device (20) and the gate trench (45) of the additional transistor device (40) respectively comprise a gate electrode and a field electrode below.

14. The semiconductor die (1) of any one of the preceding claims, the gate trench (45) of the additional transistor device (40) having an elongated lateral extension and comprising an elongated gate electrode, wherein a gate contact (48), which is electrically connected to the elongated gate electrode of the additional transistor device (40), is arranged in a lateral intermediate portion (145.3), which is spaced from lateral ends (145.1, 145.2) of the elongated gate electrode.

15. The semiconductor die (1) of any one of the preceding claims, wherein the additional transistor device (40) is connected as a pulldown device (340) to the vertical transistor device (20), the vertical contact element (80) making electrical contact between a gate electrode (125) of the vertical transistor device (20) and the drain region (42) of the additional transistor device (40).

16. The semiconductor die (1) of any one of the preceding claims, comprising:
a second electrical isolation (260) in the semiconductor body (10);
wherein the second electrical isolation (260) forms a closed line around a through-contact area, in which an electrical through-contact (410) extending between the first side (10.1) and the second side (10.2) of the semiconductor body (10) is arranged.

17. The semiconductor die (1) of any one of the preceding claims, wherein the semiconductor body (10) has a thickness t of at most 40 µm.

18. A method of manufacturing the semiconductor die (1) of any one of the preceding claims, comprising:
- forming (501) the vertical transistor device (20);
- forming (502) the additional transistor device (40);
- forming (503) the electrical isolation (60) in the semiconductor body (10);
- forming (504) the vertical contact element (80).
